# EUROPEAN PATENT APPLICATION

(11) **EP 2 675 254 A1**
(43) Date of publication of application: **18.12.2013**
(21) Application number: 13172142.5
(22) Date of filing: 14.06.2013
(51) Int. Cl.: H05K 3/36, H05K 3/34

(54) **Surface mount interconnection system for modular circuit board and method**

(30) Priority: 15.06.2012 US 201213524197
(71) Applicant: Delphi Technologies, Inc., Troy, MI 48007 (US)
(72) Inventor: Snider, Chris R., Noblesville, IN Indiana 46062-4196 (US); Vadas, Robert L., Noblesville, IN Indiana 46060 (US)
(74) Representative: Robert, Vincent

(57) **Abstract**

A surface mount interconnection system (10) comprising:
first and second circuit board assemblies (12, 14), each circuit board assembly including a generally planer substrate (16, 32) having a linear array of spaced-apart solder pads (20, 36) arranged on an exposed surface (18, 34) thereof, wherein at least one of said linear arrays of solder pads (20, 36) is disposed substantially adjacent an edge (48) of the substrate (32) associated therewith, and wherein a plurality of aligned cooperating pairs of said solder pads (20, 36) are each electrically and mechanically interconnected by a solder ball (50) reflowed to form a joint (66) intermediate an associated pair of solder pads (20, 36).

## Description

### TECHNICAL FIELD

The present invention relates to apparatus for providing electrical connections to circuit boards and more particularly to providing electrical and mechanical interconnections between circuit boards.

### BACKGROUND OF THE INVENTION

The interconnection of circuit boards can pose problems with regards to cost and reliability as well as ease of assembly. With typical leaded parts header pins can be employed to eliminate connectors for reduced part count and reliability improvements.

Manufacturing processes are progressing to using more surface mount components that are driving assembly to eliminate leaded parts in favor of surface mount technology. Product designs are struggling to change over to surface mount especially for connection systems that can be expensive and not have many options available.

It is known to form a ball grid array package comprising an electronic assembly mounted to a substrate by solder bump interconnections. For example, an assembly with an encapsulated integrated circuit die may be mounted onto a mother board by solder bump interconnections. The substrate and assembly are parallel and spaced apart by a gap, with the solder bump interconnections disposed within the gap. The solder bump interconnections electrically and physically attach the substrate to the assembly via bond pads on the substrate and assembly. It has been proposed to form the interconnections using solder balls that include a polymeric core with a solder layer. The balls are placed on the pads, the substrate and assembly are aligned with the balls in between and then heated to reflow the solder. The core serves as spacer to assure minimal distance between the substrate and assembly.

During operation, the solder bump interconnections may crack due to stresses induced by thermal expansion mismatch between the assembly and the substrate, severing the electrical connection between the electronic assembly and the substrate and causing failure of the package. The distance between the surface of the substrate and the surface of the electronic assembly is referred to as the standoff height. Increasing the standoff height reduces the stresses and creates a more reliable connection. Further, it is known to locate electrical components on the substrate below the electronic assembly. The components generate heat. Increasing the standoff height between the substrate and the assembly enhances the flow of air or other cooling fluid within the gap and improves cooling of the electrical components underlying the assembly.

### SUMMARY OF THE INVENTION

The present invention is about a surface mount interconnection system which provides a method and apparatus for mounting an auxiliary printed circuit board assembly directly to a main printed circuit board assembly without the use of leaded surface mount devices. It comprises a first and a second circuit board assemblies, each circuit board assembly including a generally planer substrate, having a linear array of spaced-apart solder pads, arranged on an exposed surface. The at least one of said linear arrays of solder pads is disposed substantially adjacent an edge of the substrate associated therewith. A plurality of aligned cooperating pairs of said solder pads are each electrically and mechanically interconnected by a solder ball reflowed to form a joint intermediate an associated pair of solder pads.

Furthermore, the substrates are disposed at a mutually acute angle. Moreover the substrates are substantially rigid, or at least one of said substrates comprises a substantially flexible printed circuit board.

The said surface mount interconnection system further comprise a recessed cavity formed in one of each of said cooperating pairs of solder pads. The recessed cavity is dimensioned to affect prepositioning of an associated solder ball prior to reflow thereof.

At least a plurality of said solder balls comprise a relatively high temperature inner core and a relatively low temperature outer solder layer. They further comprise a layer of adhesive material disposed intermediate each solder ball and an associated solder pad operative to affect positional retention of said solder ball prior to reflow thereof. They also comprise a layer of flux material disposed on an outer surface of each solder ball. The solder joint includes said high temperature inner core.

The surface mount interconnection system, further comprise a protective layer of mold compound fully enveloping each said solder joint. A solder resist layer partially covering each substrate surrounds each said solder joint. Each said circuit board assembly comprises circuit traces disposed on the substrate thereof in circuit with at least some of said solder pads. In more each said circuit board assembly comprises electrical components disposed on the substrate thereof in circuit with at least some of said circuit traces.

The surface mount interconnection system further comprises cooperating locating features integrally formed by each of said substrates. The locating features are operative to affect alignment and retention of said substrates prior to reflow of said solder balls. The substrate edge is shaped to conform to an adjacent portion of the exposed surface of the other said substrate.

The adjacent solder pads in each of said linear arrays are substantially equally spaced apart. The joint comprises said high temperature inner core disposed in tangential proximity to the exposed surfaces of both of said substrates.

The invention is also relates to a method of producing a surface mount interconnection system comprising the steps of:

- forming a first, generally planer substrate for a first circuit board assembly, said first substrate having a linear array of spaced-apart solder pads arranged on an exposed surface of said first substrate and adopted for electrical interconnection with circuit elements carried on said first substrate;

- forming a second, generally planer substrate for a second circuit board assembly, said second substrate having a linear array of spaced-apart solder pads arranged on an exposed surface of said second substrate, disposed substantially adjacent an edge of said substrate , and adopted for electrical interconnection with circuit elements carried on said second substrate;

- positioning the edge of said second substrate adjacent the exposed surface of said first substrate to closely align said linear arrays of solder pads ,

- selectively placing a plurality of solder balls adjacent associated solder pad pairs and,

thermally reflowing said solder balls to form a joint extending between each of said selected solder pads , affecting an electrical and mechanical interconnection there between.

Also, the method of positioning the edge of said second substrate adjacent the exposed surface of said first substrate comprises positioning said second substrate substantially normally to said first substrate.

The method further comprises the step of applying a layer of mold compound substantially covering each said solder joint.

These and other features and advantages of this invention will become apparent upon reading the following specification, which, along with the drawings, describes preferred and alternative embodiments of the invention in detail.

### BRIEF DESCRIPTION OF THE DRAWINGS

The present invention will now be described, by way of example, with reference to the accompanying drawings, in which:

FIG. 1, is an exploded, perspective view of a first embodiment of the present invention wherein a horizontally disposed mother circuit board is illustrated juxtaposed for assembly with a vertically disposed daughter circuit board;

FIG. 2, is a broken detail view of the embodiment of Figure 1, on an enlarged scale, wherein the mother and daughter circuit boards are prepositioned in their respective assembled orientations prior to electrical and mechanical joining thereof;

FIG. 3, is a broken, detail view similar to Figure 2, depicting post-interconnection of the mother and daughter circuit boards by solder reflow process, and the subsequent application of rigid, electrically insulative underfill material;

FIG. 4, is an exploded, perspective view of a second embodiment of the present invention wherein a mother circuit board is illustrated juxtaposed for assembly with an adjacent flexible daughter circuit board;

FIG. 5, is a perspective view of a third embodiment of the present invention wherein a daughter circuit board has a number of solder balls preassembled therewith by a "pick and place" process wherein the solder balls are adhered by an adhesive or solder reflowing process;

FIGs. 6A, B and C, are perspective views of assembly process steps of the third embodiment wherein a solder pallet is provided (Figure 6A), the solder pallet is prepositioned atop the mother circuit board to support the daughter circuit board normally thereto (Figure 6B), and the solder pallet is removed from the completed mother-daughter circuit board assembly (Figure 6C); and

FIG. 7, is an enlarged detail of a portion of Figure 6C illustrating the solder joints affecting mechanical and electrical interconnection of the mother and daughter circuit boards.

Although the drawings represent embodiments of the present invention, the drawings are not necessarily to scale and certain features may be exaggerated in order to illustrate and explain the present invention. The exemplification set forth herein illustrates an embodiment of the invention, in one form, and such exemplifications are not to be construed as limiting the scope of the invention in any manner.

### DESCRIPTION OF THE PREFERRED EMBODIMENT

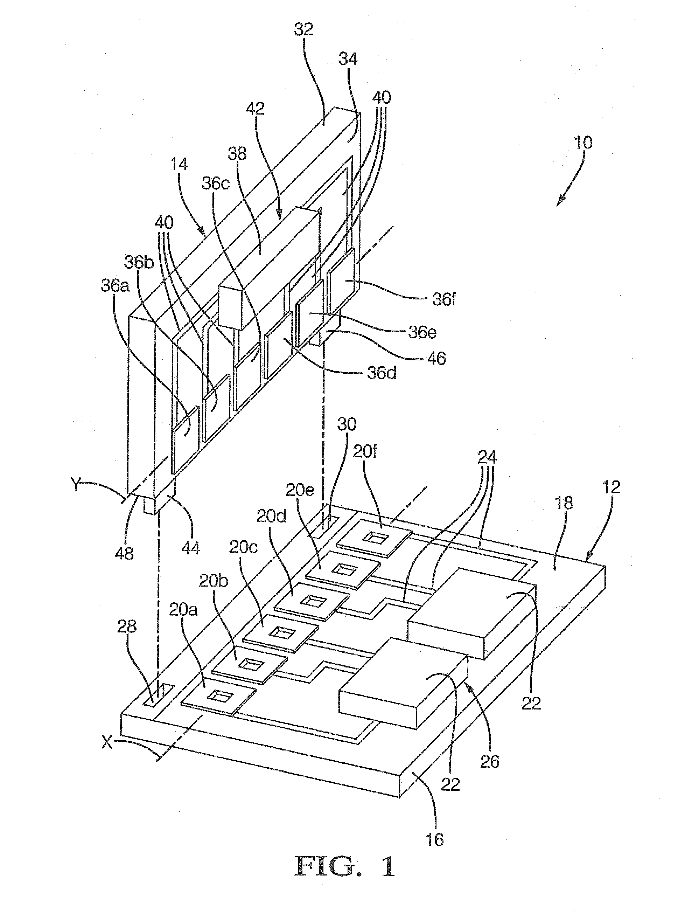

Referring to Figure 1, an electronic package 10 embodying the present invention is illustrated. The electronic package 10 comprises a main circuit board assembly 12 and an auxiliary circuit board assembly 14 adapted to be selectively electrically and mechanically joined. The main circuit board assembly 12 has a generally planer substrate 16, such as a rigid printed circuit board (PCB), forming an exposed (upper) surface 18. A linear array of spaced-apart solder pads 20a - 20f is carried on the exposed surface 18 of substrate 16 along an axis designated X - X. Each solder pad 20 is electrically interconnected with various electrical components 22 by one or more conductive traces 24. The solder pads 20a - 20f, electrical components 22 and conductive traces 24 form a main or first sub-circuit assembly 26. A pair of spaced-apart locating features 28 and 30, such as shaped recesses are formed in the substrate 16, opening into the exposed surface 18 near the array of solder pads 20a - 20f. Each of the solder pads 20a - 20f are preferably similarly configured (shaped and dimensioned), and adjacent solder pads 20a - 20f are equally spaced from one another.

The auxiliary circuit board assembly 14 has a generally planer substrate 32, such as a rigid printed circuit board (PCB), forming an exposed (rightwardly facing) surface 34. A linear array of spaced-apart solder pads 36a - 36f is carried on the exposed surface 34 of substrate 32 along a designated axis Y - Y. Each solder pad 36 is electrically interconnected with various electrical components 38 by one or more conductive traces 40. The solder pads 36a - 36f, electrical components 38 and conductive traces 40 form an auxiliary or second sub-circuit assembly 42. A pair of spaced-apart locating tabs 44 and 46, such as shaped extensions are formed in the substrate 32, extending (downwardly) from a bottom edge surface 48 normally adjacent the exposed surface 34 in slip fit engagement within locating features 28 and 30, respectively. The array of solder pads 36a - 36f are located at or very near the line of intersection of the exposed surface 34 and the bottom edge surface 48. Each of the solder pads 36a - 36f are preferably similarly configured (shaped and dimensioned), and adjacent solder pads 36a - 36f are equally spaced from one another.

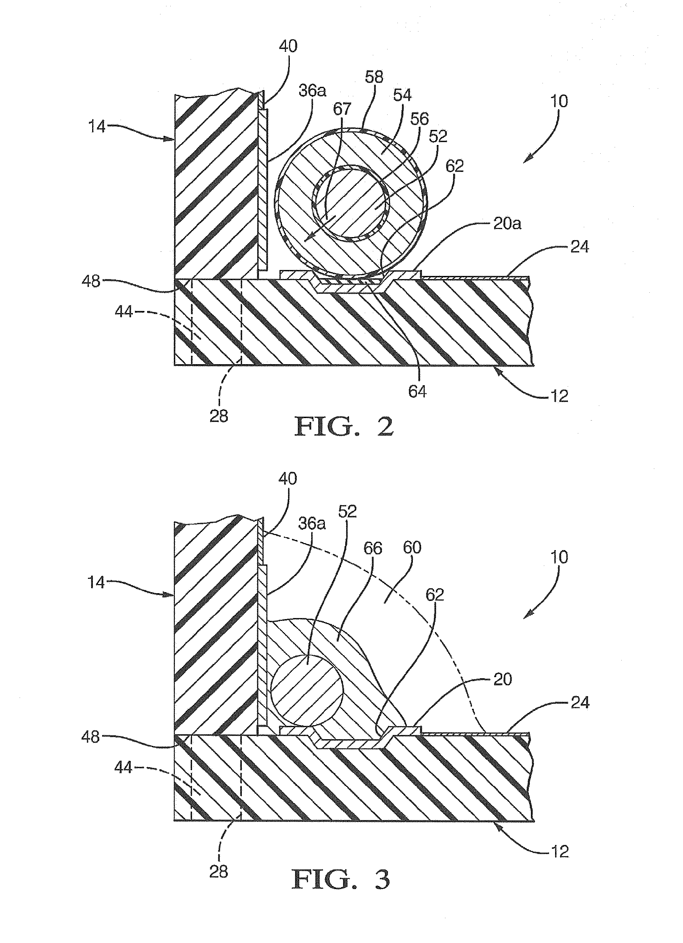

Referring now to Figures 2 and 3, there is shown an arrangement of main circuit board assembly 12 and auxiliary circuit board assembly 14 combined for forming package 10. Solder resist covers the exposed surfaces 18 and 34 of substrates 16 and 32, respectively, carrier surface 26, with the exception of the solder pads 20a - 20f and 36a - 36f, respectively.

Referring to Figures 1 and 2, initial assembly steps for surface mounting the auxiliary circuit board 14 on the main circuit board 12 are illustrated. Preferably, the auxiliary circuit board assembly 14 and the main circuit board assembly 12 are separately preassembled. Thereafter, the auxiliary circuit board assembly 14 is prepositioned normally on the main circuit board assembly 12, with the bottom edge surface 48 of the auxiliary circuit board substrate 32 abutting the exposed upper surface 18 of the main circuit board substrate 16. The integral locating tabs 44 and 46 of the auxiliary circuit board assembly 14 are precisely slip-fit within the mating locating features 28 and 30, respectively, formed in the substrate 16 of the main circuit board assembly 12.

Axis X - X defining the linear array of spaced-apart solder pads 20a - 20f is disposed parallel to axis Y - Y defining the linear array of spaced-apart solder pads 36a - 36f. Insodoing, the solder pads are aligned in cooperating pairs. For example, solder pads 36a and 20a are aligned as a cooperating pair illustrated in Figure 2. Similarly, solder pads 36b and 20b, 36c and 20c, 36d and 20d, 36e and 20e, and 36f and 20f, respectively, form cooperating pairs.

Solder balls 50 are employed to selectively electrically interconnect cooperating pairs of solder pads 20 and 36 and to mechanically affix the auxiliary circuit board assembly 14 to the main circuit board assembly 12. By selectively electrically interconnecting cooperating pairs of solder pads 20 and 36, the sub-circuit assemblies 26 and 42 are electrically placed in-circuit, creating a composite circuit. Functionality of the composite circuit can be varied by selectively employing solder balls 50 at some or all of the cooperating pairs of solder pads 20 and 36. For example, a first functionality can be achieved by placing a solder ball 50 at each cooperating pair of solder pads 20 and 36. A second functionality can be achieved by placing a solder ball 50 on solder pads 20a, 20c, 20d and 20f only (as an example), and a third functionality can be achieved by placing a solder ball 50 on solder pads 20a, 20b, 20e and 20f only (as an example). Of course, employing solder balls 50 at fewer than all of the possible solder pad pairs will result in slightly reduced structural integrity.

Each solder ball 50 can be formed of a homogenous composition. Preferably, each solder ball 50 comprises a core 52, a solder layer 54 encapsulating the core 52, and a solder wetable layer 56 disposed between core 52 and solder layer 54. Solder layer 54 is coated on its exterior layer by a flux compound 58. In a preferred embodiment, solder layer 54 is formed of a near eutectic alloy containing 63% tin and the balance lead. In the described embodiment, core 52 is formed of a polymeric material, preferably a divinylbenzene co-polymer. Alternately, the core may be formed of any suitable material that remains solid at solder reflow temperatures. Layer 56 is formed of a metal that is wet by molten solder. Suitable metals include copper or copper alloys, or nickel or nickel alloys. Suitable solder balls are commercially available from Indium Corporation under the trade designation Indium Sphereot.

Referring to Figure 3, after the substrate 14, electronic assembly 16, and solder balls 40 are arranged as depicted in Figures 1 and 2, the arrangement 10 is heated to a temperature of about 210 degrees C for a time of about 30 seconds, effective to reflow the solder. During solder reflow the solder liquefies and wets the first solder or bond pad 20 and the second solder or bond pad 36 of each respective pair, at openings in solder resist layers. The solder resist layer is patterned to create an opening that exposes the solder pads 20 and 36, allowing the top and side surfaces of the solder pads 20 and 36 to be wet with molten solder. While the solder layer 54 is in liquid form, the solid core 52 is drawn by surface tension from the position illustrated in Figure 2 to the position illustrated in Figure 3, wherein the core 52 is displaced into tangential proximity to the exposed surfaces 18 and 34 of both substratesl6 and 32, respectively, as illustrated by an arrow 67. Upon cooling, the solder solidifies and bonds to the pairs of solder pads 20 and 36 to form the solder joint interconnections. When fixed in the position illustrated in Figure 3, the core 52 serves as a web, mechanically reinforcing the substrates 16 and 32 in their respective positions illustrated in Figure 3, as well as promoting electrical conductivity between respective solder pads 20 and 36. The reformed solder 66 from the original solder layer 54 of Figure 2 also serves to structurally support the embodiment of Figure 3 and fully immerses the core 52.

After cooling of the solder joints, non-electrically conductive overflow material 60 can provide a hermetic seal over the solder joints, as well as provide supplemental structural mechanical support of the substrates 16 and 32 in their respective positions illustrated in Figure 3.

Referring to Figure 2, the solder pads 20a - 20f have a central concave recess or locating pocket 62 formed therein. The pockets 60 are each dimensioned and located to facilitate precise manual placement of a solder ball 50 prior to the reflow process step. An adhesive layer 64 can be formed in the locating pocket 62 to temporarily retain a solder ball 50 therein. Alternatively, each solder ball 50 can have an outer adhesive coating to provide the same function.

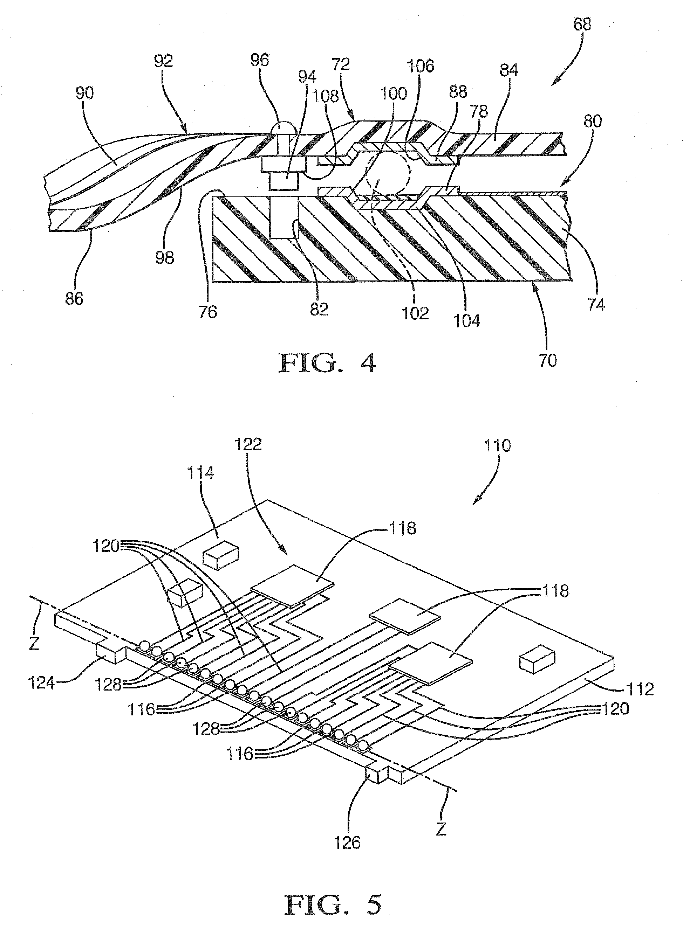

Referring to Figure 4, an electronic package 68 embodying an alternative embodiment of the invention is illustrated. The electronic package 68 comprises a main circuit board assembly 70 and an auxiliary circuit board assembly 72 adapted to be selectively electrically and mechanically joined by direct surface mount. The main circuit board assembly 70 has a generally planer substrate 74, such as a rigid printed circuit board (PCB), forming an exposed (upper) surface 76. A linear array of spaced-apart solder pads 78 (only one illustrated) is carried on the exposed surface 76 of substrate 74 along an axis. Each solder pad 78 is electrically interconnected with various electrical components by one or more conductive traces. The solder pads 78, electrical components and conductive traces form a main or first sub-circuit assembly 80. A locating feature 82, such as shaped recesses is formed in the substrate 74, opening into the exposed surface 76 near the array of solder pads 78. Each of the solder pads 78 are preferably similarly configured (shaped and dimensioned), and adjacent solder pads 78 are equally spaced from one another.

The auxiliary circuit board assembly 72 has a generally planer substrate 84, such as a flexible printed circuit board (PCB), forming an exposed (downwardly facing) surface 86. A linear array of spaced-apart solder pads 88 is carried on the exposed surface 86 of substrate 84 along a designated axis. Each solder pad 88 is electrically interconnected with various electrical components by one or more conductive traces 90. The solder pads 88, electrical components and conductive traces 90 form an auxiliary or second sub-circuit assembly 92. A pair of spaced-apart locating tabs 94, affixed to substrate 84 by a rivet 96, extend (downwardly) from a bottom edge surface 98 parallel to the exposed surface 76 of the substrate 74, in slip fit engagement within locating features 82. Each of the solder pads 88 are preferably similarly configured (shaped and dimensioned), and adjacent solder pads 88 are equally spaced from one another.

Solder pads 78 have a recess 100 formed therein for locating a solder ball 102, which is retained by an adhesive layer 104. Similarly, solder pads 88 have a recess 106 formed therein for registering with a solder ball 102.

The electronic package 68 is assembled by manually selectively placing solder balls 102 in some or all of the recesses 100 of the main sub-circuit assembly solder pads 78. Thereafter, the locating tabs 94 are registered with their corresponding locating features 82, and the solder ball 102 is heated until it reflows, interconnecting the adjoining pairs of solder pads 78 and 88 in a spaced apart relationship. Upon re-solidification of the solder, the solder pads 78 and 88 having a solder ball 102 there between are mechanically and electrically joined. The pairs of solder pads 78 and 88 lacking a solder ball remain spaced apart by a spacing step 108 formed in the locating tab 94 and are thus, mechanically and electrically isolated.

Referring to Figures 5, 6a - 6c and 7, the process steps of forming an electronic package embodying a third alternative embodiment of the invention are illustrated.

Referring to Figure 5, a main circuit board assembly 110 has a generally planer substrate 112, such as a rigid printed circuit board (PCB), forming an exposed (upper) surface 114. A linear array of spaced-apart solder pads 116 is carried on the exposed surface 114 of substrate 112 along an axis designated Z - Z. Each solder pad 116 is electrically interconnected with various electrical components 118 by one or more conductive traces 120. The solder pads 116, electrical components 118 and conductive traces 120 form a main or first sub-circuit assembly 122. A pair of spaced-apart locating features 124 and 126, such as shaped edge abutments are formed in the substrate 112, located near the array of solder pads 116. Each of the solder pads 116 are preferably similarly configured (shaped and dimensioned), and adjacent solder pads 116 are equally spaced from one another. A solder ball 128 is manually adhesively prepositioned on each solder pad 116.

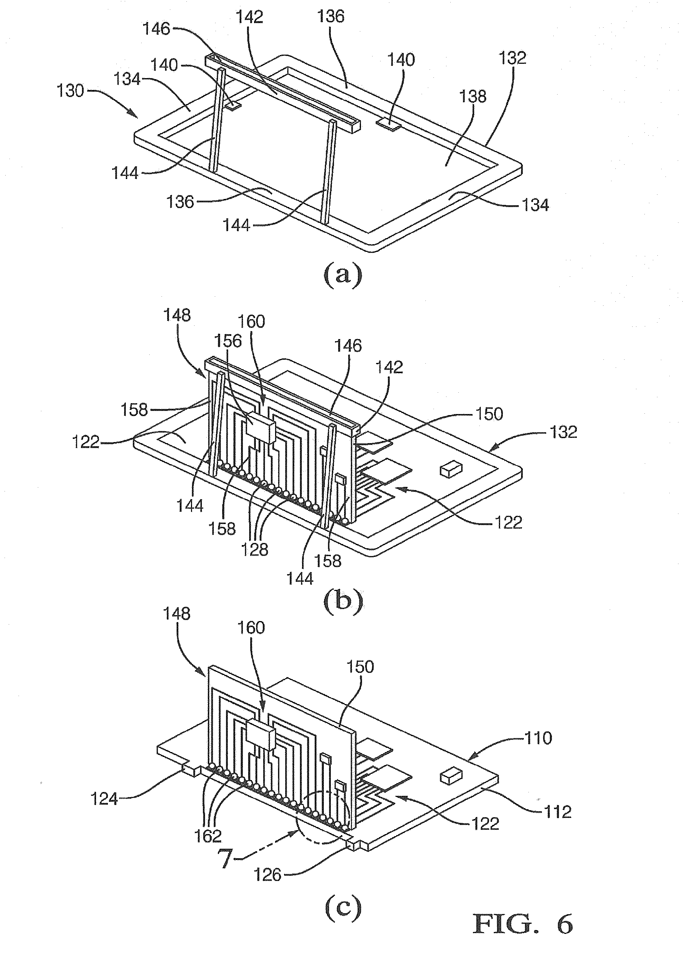

Referring to Figure 6a, an assembly fixture 130 is provided for prepositioning an auxiliary circuit board assembly on the main circuit board assembly 110 prior to soldering. The fixture 130 consists of a generally rectangular frame 132 including end wall portions 134 and side wall portions 136 configured to form an opening 138 dimensioned to precisely receive the main circuit board assembly 110 in a slip-fit. Inwardly directed locating tabs 140 are integrally formed on the end and side wall portions 134 and 136, respectively, of the frame 132 to form vertically position the main circuit board assembly 110 within the frame 132. A locating collar 142 is supported above one of the frame side wall portions 136 by two integrally formed stations 144. The locating collar 142 forms a vertically opening through slot 146.

Referring to Figure 6b, the main circuit board assembly 110 of Figure 5 is illustrated installed within the assembly fixture 130 of Figure 6a. Furthermore, Figure 6b illustrates an auxiliary circuit board assembly 148 pre=positioned with respect to the main circuit board assembly 110 and supported in a vertical orientation by the locating collar 142.

The auxiliary circuit board assembly 148 has a generally planer substrate 150, such as a rigid printed circuit board (PCB), forming an exposed surface 152. A linear array of spaced-apart solder pads 154 is carried on the exposed surface 152 of substrate 150 along a designated axis. Each solder pad 154 is electrically interconnected with various electrical components 156 by one or more conductive traces 158. The solder pads 154, electrical components 156 and conductive traces 158 form an auxiliary or second sub-circuit assembly 162. The array of solder pads 154 are located at or very near the axis Z - Z of the solder pads 116 of the main circuit board assembly. Each of the solder pads 154 are preferably similarly configured (shaped and dimensioned), and adjacent solder pads 154 are equally spaced from one another.

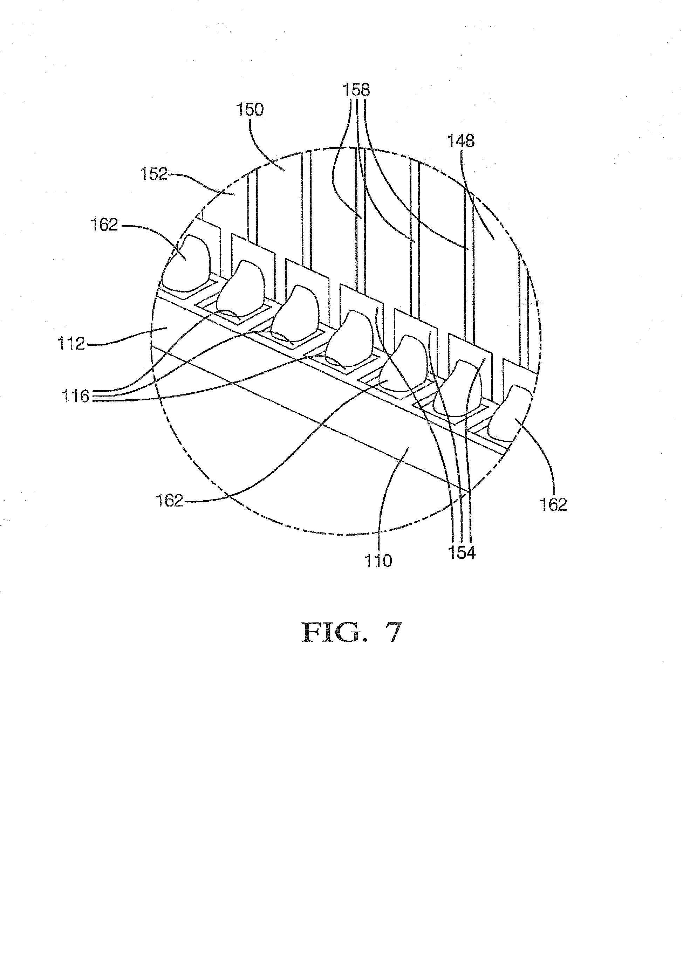

As illustrated in Figures 6b and 7, the solder pads 154 of the auxiliary circuit board assembly 148 are in precise alignment with the solder pads 116 of the main circuit board assembly 110. With the respective aligned pairs of solder pads 116 and 154 registered as illustrated in Figure 6b, the solder balls 128 are heated until they reflow, converting solder balls 128 into joints 162, as best illustrated in Figures 6c and 7. After the reflowed solder has cooled and congealed into joint 162, the assembly fixture 130 is removed. Thereafter, the auxiliary circuit board assembly 148 is mechanically supported on the main circuit board assembly 110 exclusively by the solder joints 162. As described in detail herein above, the solder joints 162 also serve to selectively interconnect the first and second sub circuit assemblies 122 and 160.

The following documents are deemed to provide a fuller disclosure of the inventions described herein and the manner of making and using same. Accordingly, each of the below-listed documents are hereby incorporated in the specification hereof by reference:

U.S. Patent No. 5,607,099 to S. Yeh et al. entitled "Solder Bump Transfer Device for Flip Chip Integrated Circuit Devices".

U.S. Patent No. 5,896,271 to Eric D. Jensen et al. entitled "Integrated Circuit with a Chip On Dot and a Heat Sink".

U.S. Patent No. 6,608,379 B2 to Youg K. Yeo et al. entitled "Enhanced Chip Scale Package for Flip Chips".

U.S. Patent No. 6,710,438 B2 to Yong K. Yeo et al. entitled "Enhanced Chip Scale Package for Wire Bond Dies".

U.S. Patent No. 7,118,940 B1 to Bruce A. Myers et al. entitled "Method of Fabricating an Electronic Package Having Underfill Standoff'.

U.S. Patent No. 7,733,659 B2 to Chris R. Snider et al. entitled "Lightweight Audio System for Automotive Applications and Method.

U.S. Patent Application No.: 2007/0029669 Al to Frank Stepniak et al. entitled "Integrated Circuit with Low-Stress Under-Bump Metallurgy".

U.S. Patent Application No.: 2007/0235217 Al to Derek B. Workman entitled "Devices with Microjetted Polymer Standoffs".

U.S. Patent Application No.: 2009/0080169 Al to Mark E. Webster et al. entitled "Method for Forming BGA Package with Increased Standoff Height".

It is to be understood that the invention has been described with reference to specific embodiments and variations to provide the features and advantages previously described and that the embodiments are susceptible of modification as will be apparent to those skilled in the art.

Furthermore, it is contemplated that many alternative, common inexpensive materials can be employed to construct the basis constituent components. Accordingly, the forgoing is not to be construed in a limiting sense.

The invention has been described in an illustrative manner, and it is to be understood that the terminology, which has been used is intended to be in the nature of words of description rather than of limitation.

Obviously, many modifications and variations of the present invention are possible in light of the above teachings. For example, ... It is, therefore, to be understood that within the scope of the appended claims, wherein reference numerals are merely for illustrative purposes and convenience and are not in any way limiting, the invention, which is defined by the following claims as interpreted according to the principles of patent law, including the Doctrine of Equivalents, may be practiced otherwise than is specifically described.

## Claims

1. A surface mount interconnection system (10) comprising:
first and second circuit board assemblies (12, 14), each circuit board assembly including a generally planer substrate (16, 32) having a linear array of spaced-apart solder pads (20, 36) arranged on an exposed surface (18, 34) thereof,
wherein at least one of said linear arrays of solder pads (20, 36) is disposed substantially adjacent an edge (48) of the substrate (32) associated therewith, and
wherein a plurality of aligned cooperating pairs of said solder pads (20, 36) are each electrically and mechanically interconnected by a solder ball (50) reflowed to form a joint (66) intermediate an associated pair of solder pads (20, 36).

2. The surface mount interconnection system (10) of claim 1, wherein said substrates (16, 32) are disposed at a mutually acute angle.

3. The surface mount interconnection system (10) as set in any of the preceding claims, wherein said substrates (16, 32) are substantially rigid, or at least one of said substrates (16, 32) comprises a substantially flexible printed circuit board (84).

4. The surface mount interconnection system (10) as set in any of the preceding claims further comprising a recessed cavity (62) formed in one of each of said cooperating pairs of solder pads (20, 36), said recessed cavity (62) dimensioned to affect prepositioning of an associated solder ball (50) prior to reflow thereof.

5. The surface mount interconnection system (10) as set in any of the preceding claims wherein at least a plurality of said solder balls (50) comprise a relatively high temperature inner core (52) and a relatively low temperature outer solder layer (54), said solder balls (50) further comprising a layer of adhesive material (64) disposed intermediate each solder ball (50) and an associated solder pad (20) operative to affect positional retention of said solder ball (50) prior to reflow thereof, and also, comprising a layer of flux material (58) disposed on an outer surface of each solder ball (50), said solder joint (66) including said high temperature inner core (52).

6. The surface mount interconnection system (10) as set in any of the preceding claims further comprising a protective layer of mold compound (60) fully enveloping each said solder joint (66).

7. The surface mount interconnection system (10) as set in any of the preceding claims further comprising a solder resist layer partially covering each substrate (16, 32) surrounding each said solder joint (66).

8. The surface mount interconnection system (10) as set in any of the preceding claims wherein each said circuit board assembly (12, 14) comprises circuit traces (24, 40) disposed on the substrate (16, 32) thereof in circuit with at least some of said solder pads (20, 36), and electrical components (22, 38) disposed on the substrate (16, 32) thereof in circuit with at least some of said circuit traces (24, 40).

9. The surface mount interconnection system (10) as set in any of the preceding claims , further comprising cooperating locating features (28, 30 & 44, 46) integrally formed by each of said substrates (16, 32), said locating features operative to affect alignment and retention of said substrates prior to reflow of said solder balls (50).

10. The surface mount interconnection system (10) as set in any of the preceding claims, wherein said substrate edge (48) is shaped to conform to an adjacent portion of the exposed surface (18) of the other said substrate (16).

11. The surface mount interconnection system (10) as set in any of the preceding claims wherein adjacent solder pads (20, 32) in each of said linear arrays are substantially equally spaced apart.

12. The surface mount interconnection system (10) as set in any of the preceding claims wherein said joint (66) comprises said high temperature inner core (52) disposed in tangential proximity to the exposed surfaces (18, 34) of both of said substrates (16, 32).

13. A method of producing a surface mount interconnection system comprising the steps of:
- forming a first, generally planer substrate (16) for a first circuit board assembly (12), said first substrate having a linear array of spaced-apart solder pads (20) arranged on an exposed surface (18) of said first substrate and adopted for electrical interconnection with circuit elements (22) carried on said first substrate (16);
- forming a second, generally planer substrate (32) for a second circuit board assembly (14), said second substrate having a linear array of spaced-apart solder pads (36) arranged on an exposed surface (34) of said second substrate, disposed substantially adjacent an edge (48) of said substrate (32), and adopted for electrical interconnection with circuit elements (38) carried on said second substrate (32);
- positioning the edge (48) of said second substrate (32) adjacent the exposed surface (18) of said first substrate (16) to closely align said linear arrays of solder pads (20, 36);
- selectively placing a plurality of solder balls (50) adjacent associated solder pad pairs (20, 36); and
- thermally reflowing said solder balls (50) to form a joint (66) extending between each of said selected solder pads (20, 36) affecting an electrical and mechanical interconnection there between.

14. The method of claim 13, wherein said step of positioning the edge (48) of said second substrate (32) adjacent the exposed surface (18) of said first substrate (16) comprises positioning said second substrate (32) substantially normally to said first substrate (16).

15. The method of claim 13 or 14, further comprising the step of applying a layer of mold compound (60) substantially covering each said solder joint (66).
